# EUROPEAN PATENT APPLICATION

(11) **EP 4 351 276 A1**
(43) Date of publication of application: **10.04.2024**
(21) Application number: 22811685.1
(22) Date of filing: 27.05.2022
(51) Int. Cl.: H05B 6/12, F24C 15/00, H05K 7/20

(54) **MICROWAVE OVEN**

(30) Priority: 28.05.2021 KR 20210069399; 27.12.2021 KR 20210188450
(71) Applicant: LG Electronics Inc., Yeongdeungpo-gu Seoul 07336 (KR)
(72) Inventor: KIM, Seunghak, Seoul 08592 (KR); CHO, Junghyeon, Seoul 08592 (KR); PARK, Myoeng Soo, Seoul 08592 (KR); LEE, Ji Won, Seoul 08592 (KR)
(74) Representative: Vossius & Partner Patentanwälte Rechtsanwälte mbB
(86) International application number: PCT/KR2022/007568
(87) International publication number: WO 2022/250494

(57) **Abstract**

Disclosed is a microwave oven. The microwave oven disclosed herein has a first electronic component group disposed on the inside of an air guide, and a second electronic component group disposed on the outside of a first side of the air guide, and includes an air discharge hole on an outer wall of the first side of the air guide, such that a portion of air flowing into the air guide to cool the first electronic component group may be provided to the second electronic component group. Accordingly, both the first electronic component group and the second electronic component group can be cooled.

## Description

### [Technical Field]

The present disclosure relates to an electric range, and more specifically to an electric range having a structure capable of effectively cooling an inside of the electric range.

### [Background Art]

In homes or restaurants, various types of cooking utensils for heating food are used. The cooking utensils include a gas stove using gas and an electric range using electricity.

An electric range is roughly divided into a resistance heating type electric range and an induction heating type electric range.

The resistance heating type electric range generates heat by applying a current to a metal resistance line or a nonmetal heating element such as silicon carbide, and heats an object to be heated (e.g. a cooking vessel such as a pot or frying pan) by radiating or conducting the generated heat.

The induction heating type electric range generates a magnetic field around a coil by applying high frequency power to the coil, and heats an object to be heated made of a metallic material, by using an eddy current generated from the generated magnetic field.

The basic principle of induction heating is as follows. When current is applied to a working coil or a heating coil, heat is generated through induction heating of the object to be heated, and the object to be heated is heated by the generated heat.

As a conventional art related to this, Korea Registered Patent No. 1,291,428 discloses a cooking appliance that operates by induction heating.

A conventional cooking appliance includes an inverter module including an inductive heating unit and electric devices that supply power to the inductive heating unit, a heat sink on which a heat-generating electric device (electronic device) among the electric devices is mounted, a cooling fan connected to one end of the heat sink, and a flow guide (air guide) disposed on one side of the heat sink. Here, the flow guide guides a portion of the cooling air discharged from the cooling fan in the direction where the heat-generating electric device is disposed. In this case, a gap is formed laterally below the flow guide, and air is discharged to the outside of the flow guide.

As another conventional art, Korea Registered Patent No. 1,878,048 discloses a cooking appliance that operates by induction heating.

In other conventional cooking appliances, a duct delivers outside air to the inside of the cooking appliance through a lateral extension section. Additionally, a guide cover (air guide) covers the heat-generating chip and heat sink, separating the chip (electronic device) and the heat sink from the inner space of the cooking appliance, and the air discharged from the fan flows into the chip and heat sink. In this case, a gap is formed below the guide cover in the lateral direction, and air is discharged to the outside of the guide cover.

However, the conventional technologies have the following problems.

In the conventional technologies, because the air guide extends straight, the air that cools the heat sink and the electronic device is heated and discharged to the outside. Therefore, the cooling efficiency of electronic devices located outside the air guide is reduced.

In addition, in the conventional technologies, since the lateral lower portion of the air guide is completely open, flow loss occurs in the lateral direction along the entire length of the air guide. Accordingly, the flow rate of air from the entrance to exit of the air guide becomes slow, so it impossible to efficiently cool both the electronic devices inside and the outside of the guide cover.

Additionally, in the conventional technologies, a gap discharging air to the outside of the air guide is adjacent to the electric housing and adjacent to the lower side of the heat sink. Here, since the heat sink has a trapezoidal shape, the flow rate of air flowing to the lower side of the heat sink is smaller than the flow rate of air flowing to the upper side of the heat sink. Therefore, a sufficient amount of cooling air cannot be provided to external electronic devices through the gap.

### [Disclosure]

### [Technical Problem]

An object of the present disclosure is to provide an electric range having a structure that can effectively suppress overheating of a printed circuit board mounted therein and increase cooling efficiency of the printed circuit board.

In addition, an object of the present disclosure is to provide an electric range having a structure capable of efficiently cooling both a heat sink and first group of electronic devices disposed on the inside of an air guide and a second group of electronic devices disposed on the outside of the air guide.

In addition, an object of the present disclosure is to provide an electric range having a structure capable of cooling a second group of electronic devices disposed on the outside of an air guide without reducing the cooling efficiency of a first group of electronic devices disposed on the inside of the air guide.

In addition, an object of the present disclosure is to provide an electric range having a structure capable of providing relatively cold air to a second group of electronic devices disposed outside an air guide.

In addition, an object of the present disclosure is to provide an electric range having a structure capable of providing a sufficient amount of air to a second group of electronic devices disposed outside an air guide.

In addition, an object of the present disclosure is to provide an electric range that can cool both electronic devices mounted on a printed circuit board and a control board disposed on the outside of an air guide.

Objectives of the present disclosure are not limited to what has been described. Additionally, other objectives and advantages that have not been mentioned may be clearly understood from the following description and may be more clearly understood from embodiments.

### [Technical Solution]

In an electric range according to an embodiment of the present disclosure, a first group of electronic devices is disposed on the inside of an air guide, a second group of electronic devices is disposed on the outside of the first side of the air guide, and an air discharge hole is formed in the outer wall of the first side of the air guide, so that a portion of the air that flows inside the air guide and cools the first group of electronic devices can be provided to the second group of electronic devices. Accordingly, both the first group of electronic devices and the second group of electronic devices can be cooled.

In addition, in an electric range according to an embodiment of the present disclosure, the air discharge hole may be formed in front of the second inner electronic device that generates a large amount of heat among the plurality of inner electronic devices included in the first group of electronic devices. Accordingly, relatively cool air can be provided to the second group of electronic devices, and the cooling efficiency of the second group of electronic devices can be increased.

In addition, an electric range according to an embodiment of the present disclosure includes part A of the air guide adjacent to a communication portion in communication with an air blower fan, and part B of the air guide farther from the communication portion than part A. In this case, the area of part A is larger than the area of part B, and the air discharge hole may be formed in part A at a boundary between part A and part B. Accordingly, the decrease in cooling efficiency of the first group of electronic devices disposed in part B can be minimized.

In addition, in an electric range according to an embodiment of the present disclosure, a first outer electronic device whose height is greater than a lower end of the air discharge hole among a plurality of outer electronic devices included in the second group of electronic device group may be disposed. Accordingly, the air discharged from the air discharge hole collides with the first external electronic device and flows to the outside rear side of the air guide, thereby cooling a control board disposed at the rear side of the air guide.

In addition, in an electric range according to an embodiment of the present disclosure, the lower end of the air discharge hole can be formed to be spaced apart from the printed circuit board by a preset distance. In this case, the height of the lower end of the air discharge hole may be greater than the height of the lower surface of the heat sink disposed inside the air guide. Accordingly, a portion of the air flowing to the upper portion of the heat sink is discharged through the air discharge hole. Accordingly, the flow rate of air discharged through the air discharge hole can increase, and the cooling efficiency of the second group of electronic devices can be increased.

In addition, in an electric range according to an embodiment of the present disclosure, the air discharge port may be formed in the air guide adjacent to the air blower fan. Accordingly, the flow rate of air provided to the second group of electronic devices can be further increased, and the cooling efficiency of the second group of electronic devices can be increased.

In addition, an electric range according to an embodiment of the present disclosure includes a case which is coupled to an upper end of a cover plate, a heater which is disposed on a lower portion of the cover plate, an upper bracket which is disposed on a lower portion of the heater, a base bracket which is disposed on a lower portion of the upper bracket and on which a printed circuit board equipped with a plurality of electronic devices including a first group of electronic devices and a second group of electronic devices is installed, a heat sink which is installed on the printed circuit board, an air blower fan which is installed on the base bracket and discharges air toward the heat sink, and an air guide which is mounted on the printed circuit board to surround the first group of electronic devices and the heat sink, communicates with the air blower fan, and forms a flow path of the air discharged from the air blower fan. In this case, the air guide may include an air discharge hole which provides a portion of the air flowing to the first side of the heat sink to the second group of electronic devices disposed outside the air guide.

In addition, an electric range according to another embodiment of the present disclosure includes a case which is coupled to an upper end of a cover plate, a heater which is disposed on a lower portion of the cover plate, an upper bracket which is disposed on a lower portion of the heater, a base bracket which is disposed on a lower portion of the upper bracket and on which a printed circuit board equipped with a plurality of electronic devices including a first group of electronic devices and a second group of electronic devices is installed, a heat sink which is installed on the printed circuit board, an air blower fan which is installed on the base bracket and discharges air toward the heat sink, and an air guide which is mounted on the printed circuit board to surround the first group of electronic devices and the heat sink, communicates with the air blower fan, and forms an internal flow path of the air discharged from the air blower fan. In this case, the air guide may include a first air discharge port and second air discharge port which provide a portion of the air discharged from the air blower fan to the second group of electronic devices, the first air discharge port may be formed closer to the air blower fan than the second air discharge port, and the air discharged from the first air discharge port and the air discharged from the second air discharge port may flow along different external air flow paths.

### [Advantageous Effects]

According to the present disclosure, by forming the air discharge hole on the outer wall of the first side of the air guide, both the first group of electronic components and second group of electronic components disposed on the inside and outside of the air guide can be cooled. Accordingly, overheating of the printed circuit board on which the first group of electronic components and the second group of electronic components are mounted can be effectively suppressed.

In addition, according to the present disclosure, by forming the air discharge hole in front of the second internal electronic component with a large heat generation amount, the cooling efficiency of the second group of electronic components can be increased, and the cooling efficiency of the first group of electronic components can be reduced. Therefore, the entire printed circuit board can be efficiently cooled.

In addition, according to the present disclosure, by forming the air discharge hole at the boundary between part A and part B of the air guide, it is possible to minimize the decrease in cooling efficiency of the first electronic component disposed in part B. As a result, the first group of electronic components and the second group of electronic components can all be cooled effectively.

In addition, according to the present disclosure, by further providing the air discharged from the air discharge hole to the control board disposed at the rear side of the air guide, the control board along with the printed circuit board can be further cooled. As a result, damage to the control board can be prevented.

In addition, according to the present disclosure, by forming the bottom of the air discharge hole to be spaced apart from the printed circuit board by a preset distance, interference with other components mounted on the printed circuit board is prevented, assembly efficiency is increased, and the rigidity of the air guide may not be damaged. In addition, the flow rate of air discharged through the air discharge hole may increase.

In addition, according to the present disclosure, by forming the air discharge port in the air guide adjacent to the air blower fan, the flow rate of air provided to the second group of electronic components can be further increased, thereby further increasing the cooling efficiency of the second group of electronic components.

Detailed effects of the present disclosure are described together with the above-described effects in the detailed description of the disclosure.

### [Description of Drawings]

FIG. 1 a perspective view of an electric range according to an embodiment.
FIG. 2 is a perspective view of FIG. 1 where a cover plate is omitted.
FIG. 3 is an exploded view of FIG. 1.
FIG. 4 is a perspective view of FIG. 1 where a cover plate, a heater, and an upper bracket are omitted.
FIG. 5 is a plan view of FIG. 4.
FIG. 6 is a perspective view illustrating a state in which a printed circuit board is mounted on a base bracket 50 according to one embodiment.
FIG. 7 is a plan view of FIG. 6.
FIG. 8 is a perspective view of a heat sink according to an embodiment.
FIG. 9 is a front view of FIG. 8.
FIG. 10 is a perspective view of a base bracket according to an embodiment.
FIG. 11 is a plan view of FIG. 10.
FIG. 12 is a perspective view of a case according to an embodiment.
FIG. 13 is a plan view of FIG. 12.
FIG. 14 is a perspective view of an air guide according to a first embodiment.
FIG. 15 is a perspective view of FIG. 14 viewed from a different direction.
FIG. 16 is a plan view of FIG. 14.
FIG. 17 is a perspective view of an air guide according to a second embodiment.
FIG. 18 is a perspective view of FIG. 17 viewed from a different direction.
FIG. 19 is a plan view of FIG. 17.
FIG. 20 is a perspective view of FIG. 17 viewed from another direction.
FIG. 21 is a plan view explaining the installation structure of an air guide according to a second embodiment.
FIG. 22 is a cross-sectional view of a portion of FIG. 21.
FIG. 23 is a plan view illustrating a flow path of air inside and outside an air guide according to an embodiment of the present disclosure.
FIG. 24 is a cross-sectional view of a portion of FIG. 23.

### [Mode for Invention]

The above-described objectives, features and advantages are described in detail with reference to the attached drawings. In describing the disclosure, detailed description of known technologies in relation to the disclosure is omitted if it is deemed to make the gist of the present disclosure unnecessarily vague.

Although first, second, and the like are used to describe various components, these terms are only used to distinguish a component from another component. Through the specification, each element may be singular or plural unless particularly described otherwise. Throughout the specification, terms such as "consisting of" or "including" should not be interpreted as necessarily including all of various elements or various steps described herein and should be interpreted as indicating that additional elements or steps may be further included.

Throughout, an "upward-downward direction" denotes an upward-downward direction of an electric range in a state in which the electric range is installed for use. A "leftward-rightward direction" denotes a direction orthogonal to the upward-downward direction, and a "frontward-rearward direction" denotes a direction orthogonal to the upward-downward direction and the leftward-rightward direction. "Both lateral directions" or a "lateral direction" may have the same meaning as the leftward-rightward direction. These terms can be mixedly used herein.

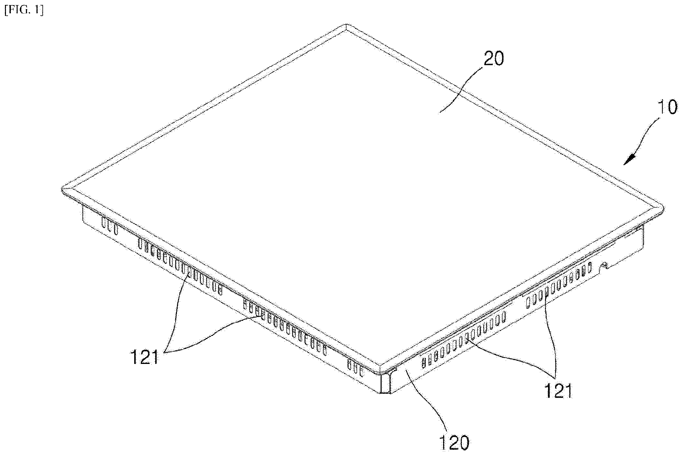

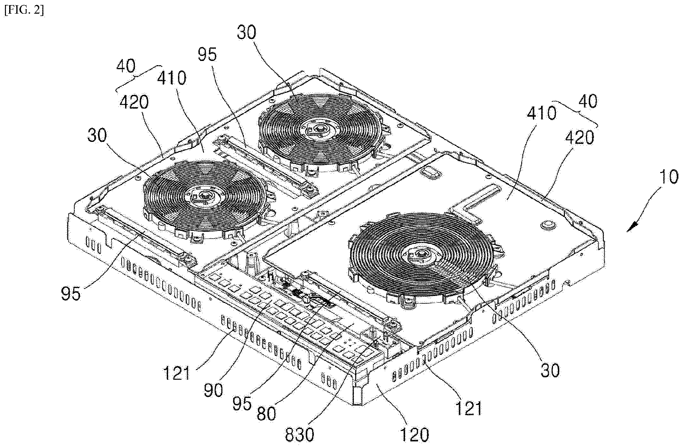

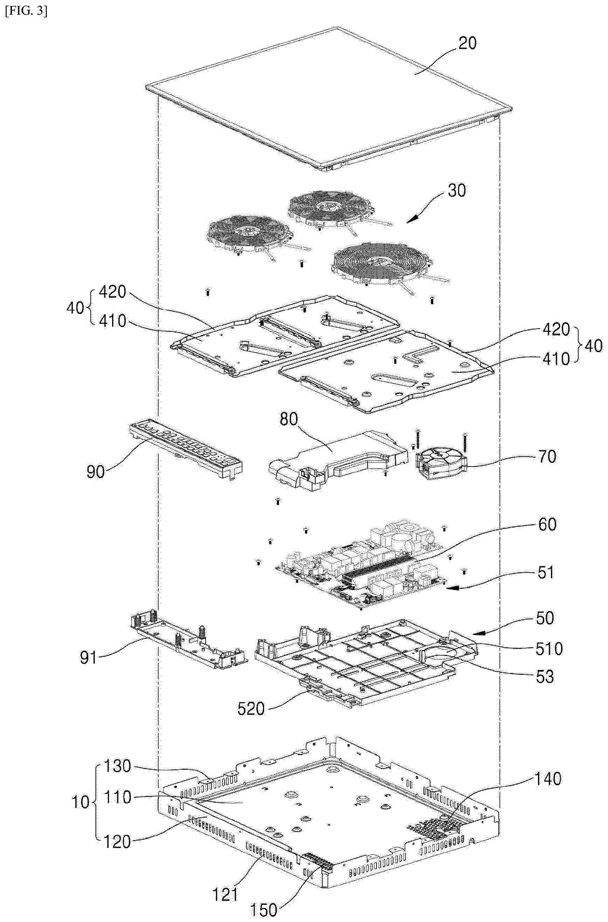

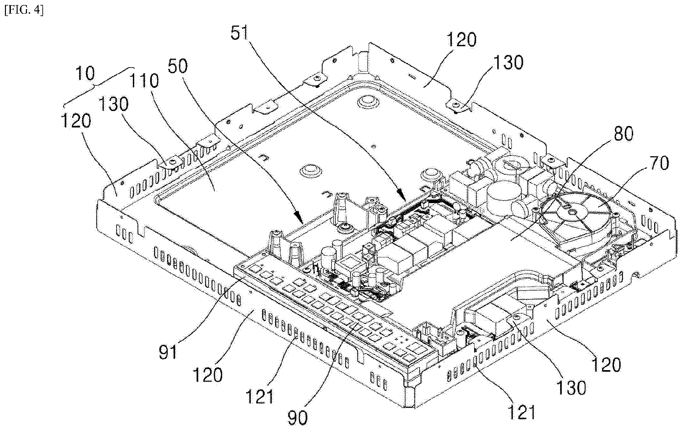

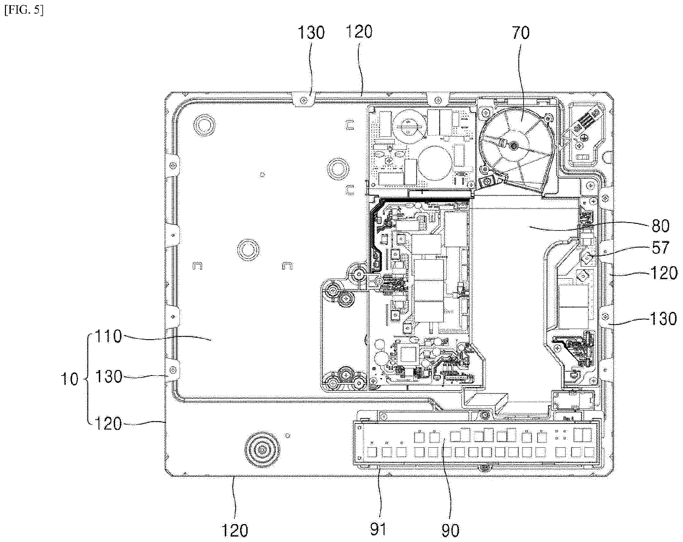

FIG. **1** a perspective view of an electric range according to an embodiment. FIG. 2 is a perspective view of FIG. 1 where a cover plate 20 is omitted. FIG. 3 is an exploded view of an electric range according to an embodiment. FIG. 4 is a perspective view of FIG. 1 where the cover plate 20, a heater 30, and an upper bracket 40 are omitted. FIG. 5 is a plan view of FIG. 4.

An electric range according to an embodiment may heat an object to be heated based on the induction heating method. In this case, an object to be heated may be a tableware containing a metal material such as stainless steel or iron.

The induction heating method includes supplying high-frequency power to a working coil to generate a magnetic field around the working coil, and heating an object to be heated made of metal, using eddy current produced by the generated magnetic field.

That is, as high-frequency power is supplied to a heating unit or heater 30 having a structure in which the working coil is adjacent to a ferrite core, a magnetic field is generated around the working coil. As an object to be heated is placed in an area of the generated magnetic field, eddy current is induced to the object to be heated by the magnetic field, and Joule's heat is generated by the eddy current, thereby heating the object to be heated. As the object to be heated is heated, a food item contained in the object to be heated is heated and cooked.

An electric range according to an embodiment may include a case 10, a cover plate 20, the heater 30, an upper bracket 40, and a base bracket 50.

The case 10 may protect components constituting the electric range. For example, the case 10 may be made of aluminum, but is not limited thereto.

Meanwhile, the case 10 may be thermally insulated to suppress the release of heat generated by the working coil of the heater 30 to the outside.

The case 10 may store components, such as the heater 30, the working coil, the upper bracket 40, and a control board 90 that constitute the electric range. An upper portion of the case 10 may be open. The open portion may be closed by the cover plate 20. The case 10 may be entirely formed into a box by processing plate-shaped materials.

The case 10 may include a first casing 110, a second casings 120, and a third casing 130.

The first casing 110 may form a bottom surface of the case 10. The first casing 110 may support built-in components of the above described electric range.

A printed circuit board 51 may be provided inside the first casing 110. In addition, the first casing 110 may be provided with at least one vent hole through which air flows to facilitate cooling of the plurality of electronic devices mounted on the printed circuit board 51.

The second casing 120 may be bent from the first casing 110 and may form a side surface of the case 10. The second casing 120 may be bent from an edge of the first casing 110 in an upward-downward direction to form a side wall of the electric range.

The second casing 120 may be disposed on each side of the first casing 110 formed in a substantially quadrangular shape. The second casing 120 may reinforce a strength of an entirety of the case 10.

That is, the second casing 120 may be formed to be bent from the first casing 110 to suppress the first casing 110 having a plate shape from being warped or damaged due to a weight of the built-in components or an external force.

The second casing 120 may further include a plurality of exhaust holes 121 formed in slit shapes. The exhaust holes 121 may allow an inside and outside of the case 10 to communicate with each other. Accordingly, since air flows through the exhaust holes 121, the components accommodated in the case 10 can be cooled. The third casing 130 may be bent from the second casing 120 and may support the upper bracket 40. The third casing 130 may be disposed on each side of the first casing 110.

A first upper plate 410 forming a bottom surface of the upper bracket 40 may be seated on an upper surface of the third casing 130. The first upper plate 410 and the third casing 130 may be coupled by a coupling unit, such as a bolt.

The cover plate 20 may be coupled to an upper end of the case 10. The cover plate 20 may close the open upper portion of the case 10 to protect the components accommodated in the case 10.

An object to be heated may be placed on the upper surface of the cover plate 20, and a magnetic field generated by the heater 30 may pass through the cover plate 20 and reach the object to be heated. The cover plate 20 may be formed of a material containing, for example, a ceramic, but is not limited thereto.

An input interface through which an input is received from a user may be installed on the upper surface of the cover plate 20. The input interface may be installed in a specific region of the upper surface of the cover plate 20 and may display a specific image.

A touch input may be received from the user through the input interface, and the electric range may be driven on the basis of the received touch input.

For example, the input interface may be a module for a user to input a desired heating intensity or heating time and may be implemented as a physical button, or touch panel.

For example, the input interface may be a thin film transistor liquid crystal display (TFT LCD), but is not limited thereto.

The control board 90 which inputs an operation command to the electric range may be provided on a lower portion of the cover plate 20. A plurality of key switches may be provided on the control board 90. The user may input a command to the control board 90 through the plurality of key switches to control operation of the electric range.

In an electric range according to an embodiment, a board support 91 may be provided to stably install the control board 90 in the case 10. The board support 91 may be installed in the case 10, and the control board 90 may be installed on the board support 91.

The board support 91 may be manufactured in a shape that allows the board support 91 and the control board 90 to be stably installed. The board support 91 may be formed of a plastic material, which is electrically insulative and is easily injection-molded, in order to be easy to manufacture, light, and electrically insulative, but the material is not limited thereto.

In an electric range according to an embodiment, an upper surface of the control board 90 may be provided to be pressed against a lower surface of the cover plate 20. In this case, the control board 90 may be disposed at a location corresponding to the input interface.

In this case, the control board 90 and the input interface may be connected to each other in a capacitive touch input manner. Accordingly, when the user inputs a control command through the input interface, the control command may be input to the control board 90.

In addition, a display on which a drive state of the electric range is displayed may be provided in a specific region of the upper surface of the cover plate 20.

A light display region may be formed in the upper surface of the cover plate 20. Alight source unit 95 may be disposed on a lower surface of the cover plate 20, and light emitted by the light source unit 95 may be transmitted to the user through the light display region.

In this case, the light display region and the light source unit 95 may be disposed at locations corresponding to each other. When a plurality of light source units 95 is provided, light display regions equal in number to the light source units 95 may also be provided in the upper surface of the cover plate 20.

An electric range according to an embodiment may further include a cover bracket that supports the cover plate 20. An upper surface of the cover bracket may support the cover plate 20, and the cover bracket may be coupled to the second casing 120 of the case 10 by a coupling unit, such as a screw bolt.

The plurality of heater 30 may be provided, and the plurality of heaters 30 may be disposed on a lower surface of the cover plate 20, and may heat an object to be heated.

According to an embodiment, the plurality of heaters 30 may be provided to operate through an induction method.

According to another embodiment, some of the plurality of heaters 30 may be provided to operate through an induction heating method, while the rest of the plurality of heaters 30 may be provided to operate through an electric resistance heating method. That is, an electric range may be provided as a highlight heater or a hybrid range.

Hereinafter, an electric range in which all the plurality of heaters 30 is provided to operate through the induction heating method will be described.

The heater 30 may be installed on the upper bracket 40, and in this embodiment, a total of three heaters 30 may be provided. Apparently, the number of the heaters 30 is not limited thereto. When the plurality of heaters 30 is provided, the upper bracket 40 that supports the heaters 30 may also be provided as a plurality of upper brackets 40 as necessary.

The heater 30 may include a core frame, the working coil may be spirally wound on an upper surface of the core frame, and the ferrite core may be installed on a lower surface of the core frame. Accordingly, when high frequency power is applied to the working coil, a magnetic field may be generated around the ferrite core, and the generated magnetic field may generate an eddy current in an object to be heated.

The upper bracket 40 may be disposed on a lower portion of the heater 30 and may support the heater 30. In this embodiment, the upper bracket 40 may be provided as the plurality of upper brackets 40. For example, the upper bracket 40 may be formed of an aluminum material, but is not limited thereto.

The upper bracket 40 may be manufactured as a structure that supports the heater 30 by processing a plate metal in substantially a box shape.

The upper bracket 40 may include a first upper plate 410 and a second upper plate 420. The first upper plate 410 may form the bottom surface of the upper bracket 40, and the heater 30 may be installed on the first upper plate 410.

The first upper plate 410 may hide the printed circuit board 51 provided thereunder in the upward-downward direction. When the plurality of upper brackets 40 is provided, one first upper plate 410 or a plurality of first upper plates 410 combined with each other may hide the printed circuit board 51 according to an area of the printed circuit board 51.

Due to this structure, the first upper plate 410 may serve to block an electromagnetic field and electromagnetic waves generated by the heater 30 from reaching the printed circuit board 51 and devices mounted on the printed circuit board 51.

That is, the upper bracket 40 may serve to improve the performance of electromagnetic compatibility (EMC) and electromagnetic interference (EMI) for the printed circuit board 51.

The second upper plate 420 may be bent from the first upper plate 410 in the upward-downward direction of the electric range. The second upper plate 420 may be formed to be bent from an edge of the first upper plate 410 in the upward-downward direction.

The second upper plate 420 may be disposed on each side of the first upper plate 410 formed in a substantially quadrangular shape. When the plurality of upper brackets 40 is provided, the second upper plate 420 may be provided on the respective sides of the first upper plate 410 excluding sides adjacent to each other of the upper brackets 40.

The second upper plate 420 may reinforce a strength of an entirety of the upper bracket 40. That is, the second upper plate 420 may be formed to be bent from the first upper plate 410 to suppress warping of or damage to the first upper plate 410 due to a weight of built-in components including the heater 30 or an external force.

The light source unit 95 may be disposed on the upper bracket 40. For example, the light source unit 95 may be provided on the printed circuit board 51 disposed on a lower portion of the upper bracket 40, and an opening disposed at a location corresponding to the light source unit 95 may be formed in the upper bracket 40.

As another embodiment, light source unit 95 may be disposed on upper bracket 40, and the light source unit 95 may also be electrically connected to printed circuit board 51 disposed thereunder. In FIGS. 2 and 3, a structure in which the light source unit 95 is disposed on the upper bracket 40 is illustrated as an example of an electric range.

As described above, the light display region may be formed on the cover plate 20 at a portion corresponding to the light source unit 95. For example, the light source unit 95 may be provided in a form in which a plurality of light emitting diodes (LEDs) is arranged in a line.

When the heater 30 operates, the light source unit 95 may be turned on to notify the user of whether the heater 30 is operated. Alternatively, the light source unit 95 may also change a lighting shape, color, or the like of the plurality of LEDs to notify the user of a state in which the electric range is operating.

A number of the light source units 95 may be properly selected according to the number of the heater 30. In FIGS. 2 and 3 , three light source units 95 are provided to correspond to three heaters 30. However, the number of the light source units 95 is not limited thereto.

The base bracket 50 may be disposed on lower portions of the heater 30 and upper bracket 40, and the printed circuit board 51 may be installed on the base bracket 50. The base bracket 50 may include a bottom plate and a side plate.

The bottom plate may form a bottom surface of the base bracket 50, and the printed circuit board 51 may be installed on an upper surface of the base bracket 50.

The side plate may be bent from the bottom plate in the upward-downward direction of the electric range. The side plate may be bent from an edge of the bottom plate in the upward-downward direction.

The side plate may be disposed on each side of the bottom plate formed in a substantially quadrangular shape. When the plurality of upper brackets 40 is provided, the side plate may be formed on the sides of the bottom plate excluding sides adjacent to each other of the upper bracket 40.

The side plate may reinforce a strength of an entirety of the base bracket 50. That is, the side plate may be formed to be bent from the bottom plate to suppress the bottom plate having a board shape from being warped or damaged due to a weight of built-in components, such as the circuit board, or an external force.

The base bracket 50 may be formed of a plastic material, which is electrically insulative and is easily injection-molded, in order to be easy to manufacture, light, and electrically insulative, but the material is not limited thereto.

The printed circuit board 51 may constitute a controller. The printed circuit board 51 may receive power from an external power source and may be provided to communicate with an external device in a wired or wireless manner.

A wireless communication circuit board (WiFi PCB) may be installed in the electric range in order to wirelessly communicate with an external device. The printed circuit board 51 may be electrically connected to the wireless communication circuit board.

The printed circuit board 51 may be electrically connected to the control board 90 and may receive a command input by the user from the control board 90. The printed circuit board 51 may be electrically connected to the light source unit 95 and the working coil and may control operation of the light source unit 95 and the working coil.

A heat sink 60 may be mounted on the printed circuit board 51. A plurality of electronic components for operation of the electric range may be mounted. Accordingly, a drive circuit for driving the heater 30 may be formed on the printed circuit board 51.

A plurality of electronic components may generate heat when an electric range is operated. For example, the drive circuit includes a plurality of electronic components such as a rectifier, a DC link capacitor, an inverter, a resonance capacitor, a snubber capacitor, a shunt resistor, etc., and the plurality of electronic components may generate heat during operation. If the temperature of a plurality of electronic components is high, the electric range may stop working or malfunction.

Accordingly, an electric range may further include the heat sink 60, an air blower fan 70, and an air guide 80 to cool a plurality of electronic components.

The heat sink 60 may cool heat inside of the case 10 to protect the electronic components accommodated in the case 10. The heat sink 60 may be mounted on the printed circuit board 51. The heat sink 60 may have an overall trapezoidal shape. The heat sink 60 may cool heat generated due to an electromagnetic interaction when the heater 30 operates.

The air blower fan 70 may be installed on the base bracket 50 and may be provided to discharge air toward the heat sink 60. The air blower fan 70 may be electrically connected to the printed circuit board 51, and operation of the air blower fan 70 may be controlled by the controller implemented on the printed circuit board 51.

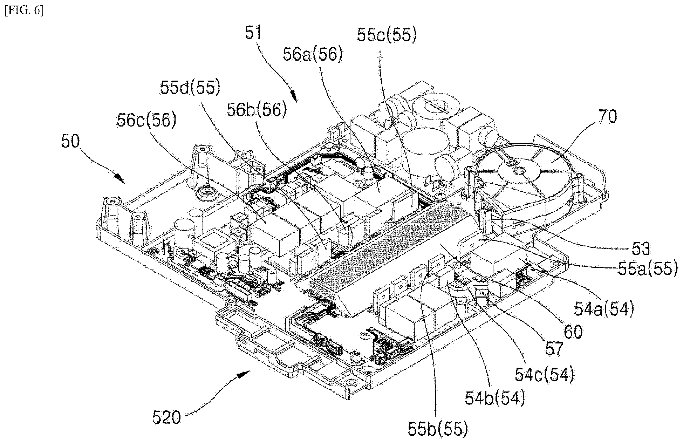

The air guide 80 may communicate with the air blower fan 70 and be provided with the air discharged from the air blower fan 70. The air guide 80 may be provided to surround the heat sink 60 and to further surround a first group of electronic components 54, 55 (see FIG. 6, etc.) among the plurality of electronic components. An internal air flow path may be formed inside the air guide 80 to cool the heat sink 60 and the first group of electronic components 54, 55. Accordingly, the air discharged from the air blower fan 70 can flow along the inner flow path to cool the heat sink 60 and the first group of electronic components 54, 55.

Referring to FIG. 5 , in order for the air forcibly moved by the air blower fan 70 to flow into the heat sink 60, a guide wall may be formed for guiding the flow of air in the direction in which the heat sink 60 is disposed at the exit of the air blower fan 70.

The detailed structure and function of the air guide 80 will be described in more detail below.

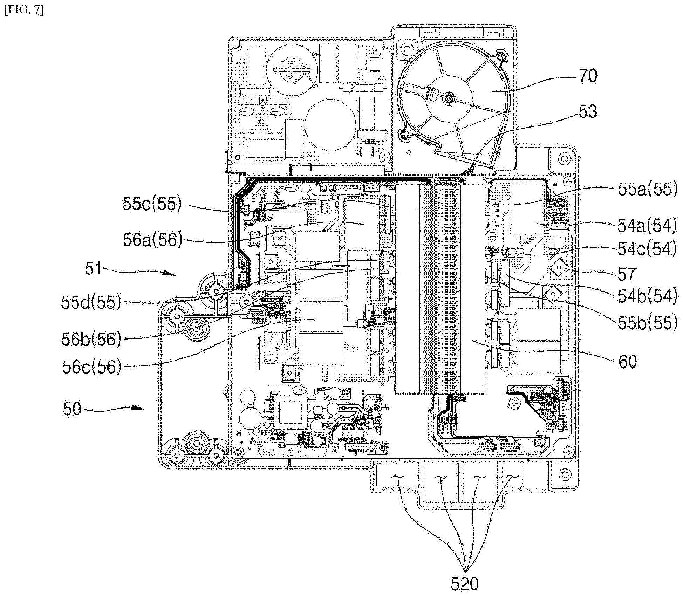

FIG. 6 is a perspective view illustrating a state in which the printed circuit board 51 is mounted on the base bracket 50 according to one embodiment. FIG. 7 is a plan view of FIG. 6.

Referring to FIGS. 6 and 7, the heat sink 60 and the plurality of electronic components may be mounted on the printed circuit board 51. Additionally, the air blower fan 70 may be mounted on the base bracket 50.

The heat sink 60 may be placed approximately at the center of the printed circuit board 51. The air blower fan 70 may be spaced from the rear side of the heat sink 60 and mounted on the base bracket 50. A lengthwise direction (that is, the frontward-rearward direction) of the heat sink 60 may be parallel with a direction in which air passing through the air guide 80 flows. Accordingly, a contact surface area and time for contact between the heat sink 60 and air forced to flow may increase, thereby enhance cooling efficiency of the heat sink 60.

A plurality of electronic components may be disposed on the printed circuit board 51. The plurality of electronic components may include a drive circuit that controls driving of the heater 30.

The drive circuit may include a rectifier, a DC link capacitor 54a, 56a, an inverter, a snubber, a capacitor 54b, 56b, a switching mode power supply (SMPS) 56c, an overcurrent protection circuit, a resonance capacitor, and a first terminal 57.

The rectifier may include a rectifying device 55a, 55c disposed on both sides of the heat sink 60. The rectifying device 55a, 55c may convert AC power supplied from an external power source into DC power. For example, the rectifying device 55a, 55c may include a bridge diode.

The DC link capacitor 54a, 56a may receive DC power from the rectifying device 55a, 55c and reduce ripple in the supplied DC power. For example, the DC link capacitor 54a, 56a may be a smoothing capacitor.

DC voltage which is rectified by the rectifying device 55a, 55c and the ripple of which is reduced by the DC link capacitor 54a, 56a may be supplied to the inverter.

The inverter may include a plurality of inverter switching devices 55b, 55d disposed on both sides of the heat sink 60. The inverter switching devices 55b, 55d may be alternately turned on or turned off by a switching signal to convert DC power to high-frequency alternating current (that is, resonance current). The converted high-frequency alternating current may be supplied to the working coil through the first terminal 57.

For example, the inverter switching device 55b, 55d may include an insulated-gate bipolar transistor (IGBT).

A plurality of snubber capacitors 54b, 56b may be connected to the inverter. That is, each of the plurality of snubber capacitors 54b, 56b may be connected to the corresponding inverter switching device 55b, 55d. A plurality of snubber capacitors 54b may be disposed on both sides of the heat sink 60. The snubber capacitor 54b, 56b is provided to reduce power loss (i.e., power loss due to hard switching) that occurs when the inverter switching device 55b, 55d is turned off, and can also remove electromagnetic noise.

An overcurrent protection circuit may be provided to suppress overcurrent from flowing through the inverter switching device 55b, 55d. To do this, the overcurrent protection circuit may include a shunt resistor 54c.

A plurality of resonance capacitors may connect respectively to the plurality of inverter switching devices 55b, 55d in parallel. As voltage is supplied based on a switching operation of the inverter, the resonance capacitor starts to resonance. Accordingly, current flowing in the working coil increases, and eddy current is induced. Accordingly, the heater 30 may be driven.

Referring to FIGS. 5 to 7, the heat sink 60 and the first group of electronic components 54, 55 may be disposed inside the air guide 80. The first group of electronic components 54, 55 may be defined as an inner group of electronic components disposed inside the air guide 80. The first group of electronic components 54, 55 may be disposed on the left (a first side) and right (a second side) sides of the heat sink 60.

The first group of electronic components 54, 55 may include a first-1 group of electronic components 55 and a first-2 group of electronic components 54.

The first-1 group of electronic components 55 may be disposed adjacent to the heat sink 60. The first-2 group of electronic components 54 may be disposed further away from the heat sink 60 than the first-1 group of electronic components 55.

The first-1 group of electronic components 55 may include a plurality of left electronic components 55c, 55d disposed on the left side of the heat sink 60 and a plurality of right electronic components 55a, 55b disposed on the right side of the heat sink 60.

The plurality of left electronic components 55c, 55d may be provided between the left side of the heat sink 60 and the left side (first side) of the air guide 80. The plurality of left electronic components 55c, 55d may include at least one first inner electronic component 55c and at least one second inner electronic component 55d. The plurality of left electronic components 55c, 55d may be sequentially disposed along the air flow path inside the air guide 80.

The at least one first inner electronic component 55c may correspond to the rectifying device 55c disposed on the left side of the heat sink 60. In the drawing, it is illustrated that one rectifying device 55c is provided, but there may be two or more rectifying devices 55c. The at least one second inner electronic component may correspond to the inverter switching device 55d disposed on the left side of the heat sink 60. In the drawing, it is illustrated that four inverter switching devices 55d are provided, but there may be only one inverter switching device 55d.

The plurality of right electronic components 55a, 55b may be provided between the right side of the heat sink 60 and the right side (second side) of the air guide 80. The plurality of right electronic components 55a, 55b may include at least one third inner electronic component 55a and at least one fourth inner electronic component 55b. The plurality of right electronic components 55a, 55b may be sequentially disposed along the air flow path inside the air guide 80.

The at least one third inner electronic component 55a may correspond to the rectifying device 55a disposed on the right side of the heat sink 60. In the drawing, it is illustrated that one rectifying device 55a is provided, but there may be two or more rectifying devices 55a. The at least one fourth inner electronic component may correspond to the inverter switching device 55b disposed on the right side of the heat sink 60. In the drawing, it is illustrated that four inverter switching devices 55b are provided, but there may be only one inverter switching device 55b.

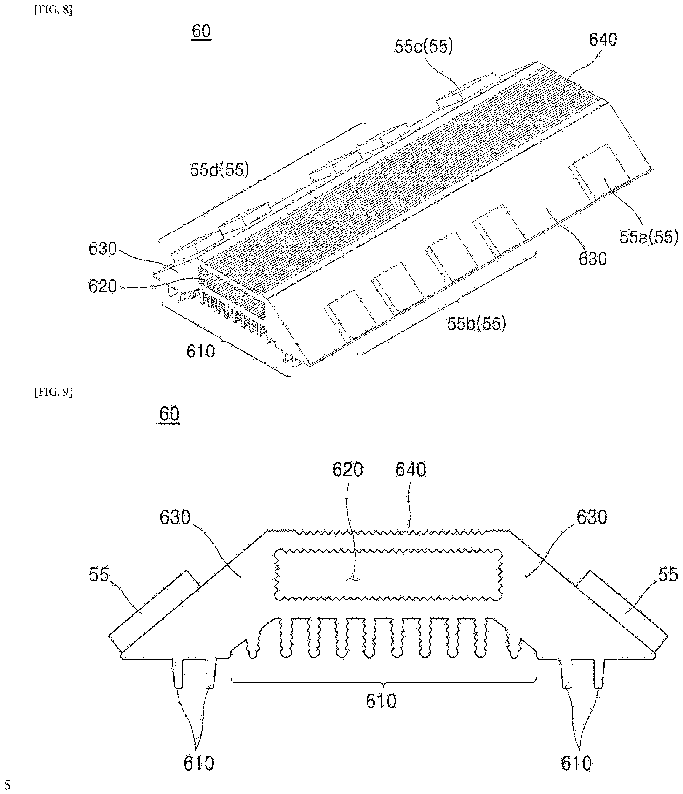

Meanwhile, the rectifying device 55a, 55c and the inverter switching device 55b, 55d may be attached to the left and right sides of the heat sink 60 (FIGS. 8 and 9) or may not be attached to the heat sink 60 (FIG. 6). When the rectifying device 55a, 55c and the inverter switching device 55b, 55d are attached to the heat sink 60, cooling efficiency can be increased.

The first-2 group of electronic components 54 may be disposed on the right side of the heat sink 60 and may include a DC link capacitor 54a, a snubber capacitor 54b, and a shunt resistor 54c.

The DC link capacitor 54a may be disposed on the right side of the heat sink 60 adjacent to the rear side (third side) of the heat sink. The snubber capacitor 54b may be disposed on the right side of the heat sink 60, closer to the front side (fourth side) of the heat sink 60 than the location where the DC link capacitor 54a is disposed. The shunt resistor 54c may be disposed between the DC link capacitor 54a and the snubber capacitor 54b.

FIG. 8 is a perspective view of the heat sink 60 according to an embodiment. FIG. 9 is a front view of the heat sink 60 according to an embodiment.

The heat sink 60 may be disposed in a longitudinal direction parallel to a flow direction of air passing through the air guide 80. Due to such structure, cooling efficiency of the heat sink 60 may be improved by increasing a contact area and a contact time between the heat sink 60 and air which is forcibly moved.

Meanwhile, the air guide 80 may also be disposed in a longitudinal direction substantially parallel to the flow direction of air to correspond to the above-described layout of the heat sink 60.

As illustrated in FIGS. 8 and 9, a plurality of cooling fins 610 may be provided on the heat sink 60. The plurality of cooling fins 610 may protrude from a lower surface of the heat sink 60 in the downward direction and may be formed parallel to the longitudinal direction of the heat sink 60. The cooling fins 610 may increase a contact area between the heat sink 60 and air to improve cooling efficiency of the heat sink 60.

The plurality of cooling fins 610 may be disposed on the lower surface of the heat sink 60 and spaced a proper interval from each other in a widthwise direction of the heat sink 60, respectively. In this case, the cooling fins 610 may be formed on an inclined portion 630 and flat portion 640 of the heat sink 60.

In addition, the heat sink 60 may include a flow pass 620 that passes through the heat sink 60 in the longitudinal direction and forms a flow path of air. The flow pass 620 may be formed in the longitudinal direction of the heat sink 60 to pass through the flat portion 640 of the heat sink 60.

The flow pass 620 may increase a contact area between the heat sink 60 and air like the cooling fin 610 to increase cooling efficiency of the heat sink 60. In this case, an irregular portion may be formed on an inner surface of the flow pass 620. The irregular portion may increase a contact area between the heat sink 60 and air to increase cooling efficiency of the heat sink 60.

The heat sink 60 may include the inclined portion 630 disposed at both sides and having an inclined upper surface and the flat portion 640 which is formed in a central portion, in which the flow pass 620 is formed, and an upper surface of which is formed as a flat surface.

An irregular portion may be formed on the upper surface of the flat part 640. The irregular portion may increase a contact area between the heat sink 60 and air to increase cooling efficiency of the heat sink 60.

The rectifying device 55a, 55c and the inverter switching device 55b, 55d may be mounted on a pair of inclined portions 630. Accordingly, the air forced to flow by the air blower fan 70 can cool the rectifying device 55a, 55c and inverter switching device 55b, 55d mounted on the inclined portion 630 of the heat sink 60. Accordingly, overheating of the rectifying device 55a, 55c and the inverter switching device 55b, 55d can be effectively suppressed.

The inclined portion 630 may have a structure whose thickness decreases toward an edge thereof. Accordingly, as the structure of the inclined portion 630 serves a function similar to that of the cooling fin 610, the electronic component 55 installed on the inclined portion 630 may be effectively cooled.

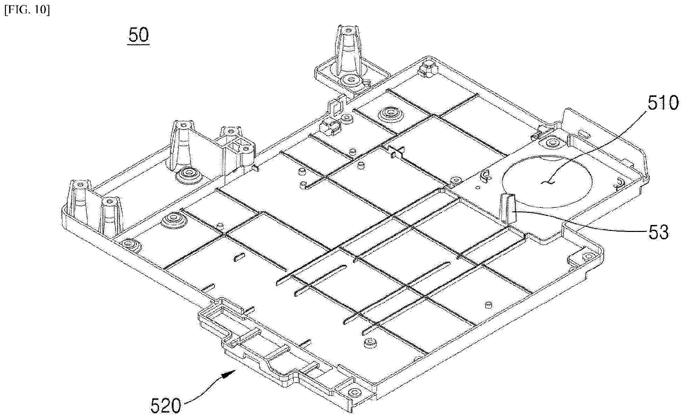

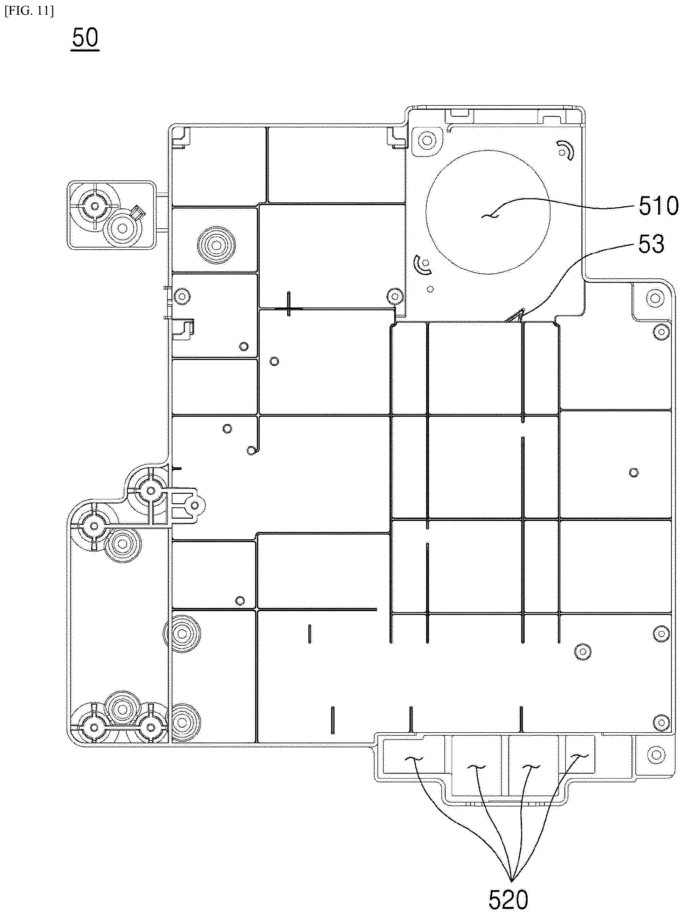

FIG. 10 is a perspective view of the base bracket 50 according to an embodiment. FIG. 11 is a plan view of the base bracket 50 according to an embodiment.

The base bracket 50 may include a first ventilation portion 510 formed in a portion corresponding to the air blower fan 70 and a second ventilation portion 520 formed in a portion corresponding to the exit of the air guide 80. In this case, the first ventilation portion 510 may be formed in a shape corresponding to a shape of the air blower fan 70, and the second ventilation portion 520 may be formed in a shape corresponding to a shape of the exit of the air guide 80.

When the air blower fan 70 operates, air may flow upward from the first ventilation portion 510 and may flow into the air blower fan 70, a flow direction of the air may be changed by the air blower fan 70, and the air may flow in the frontward-rearward direction of the electric range to pass through the air guide 80.

The flow direction of the air may be changed at the exit of the air guide 80 again, and the air may flow in the downward direction of the electric range, may pass through the second ventilation portion 520, and may be discharged to the outside of the air guide 80.

Meanwhile, the rectifying device 55a, 55c and the inverter switching device 55b, 55d may be disposed on each of the pair of inclined portions 630 of the heat sink 60. Therefore, in order to uniformly cool the rectifying device 55a, 55c and inverter switching device 55b, 55d disposed on both sides of the heat sink 60, it is necessary to guide the flow of air so that the air discharged from the exit of the air blowing fan 70 flows evenly on both sides of the heat sink 60.

Accordingly, in order for the air to uniformly flow to both sides of the heat sink 60, the electric range according to an embodiment may include a vane portion 53.

Referring to FIGS. 7, 10 and 11, the vane portion 53 may be disposed at a portion at which the air blower fan 70 communicates with the air guide 80, and the air guide 80 may control a flow direction of air so that the air uniformly flows to both sides of the heat sink 60.

For example, the vane portion 53 may be formed on the base bracket 50. As another embodiment, the vane portion 53 may be integrally formed with the air guide 80 at the entrance of the air guide 80. As still another embodiment, the vane portion 53 may also be integrally formed with a housing of the air blower fan 70 at the exit of the air blower fan 70.

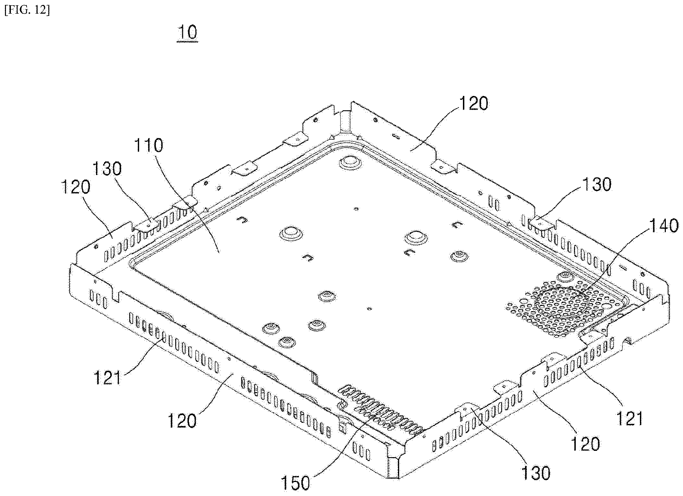

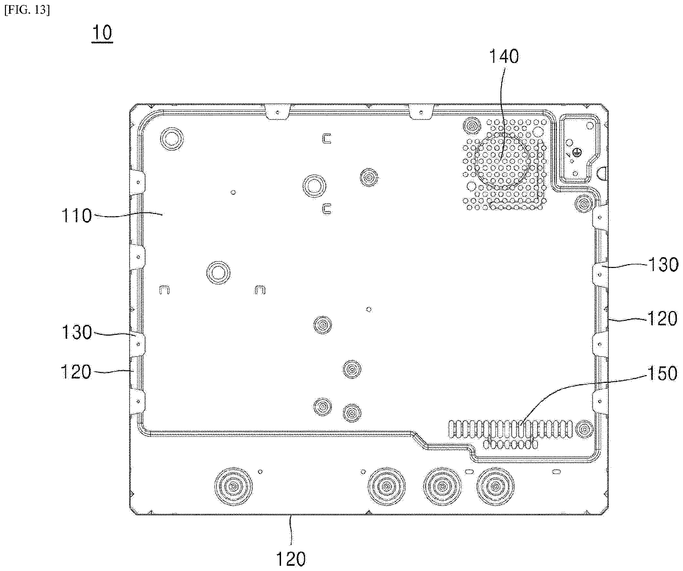

FIG. 12 is a perspective view of the case 10 according to an embodiment. FIG. 13 is a plan view of the case 10 according to an embodiment.

Referring to FIGS. 12 and 13, the case 10 may include a first through port 140 and a second through port 150 in order to allow air to be forcibly moved by the air blower fan 70 so that the air can effectively flow and be discharged.

The first through port 140 may be formed in a portion corresponding to the first ventilation portion 510, and the second through port 150 may be formed in a portion corresponding to the second ventilation portion 520. The first through port 140 and the second through port 150 may be formed by punching the first casing 110 forming the bottom surface of the case 10.

A plurality of the first through ports 140 and a plurality of the second through ports 150 may be provided. As the case 10 is an outermost wall of the electric range, the first through port 140 and the second through port 150 may be formed as holes having relatively small areas, but they are appropriately provided in plural numbers, in order to suppress external matter from flowing into the electric range through the first through ports 140 and the second through ports 150.

Hereinafter, the structure of the air guide 80 will be described in detail.

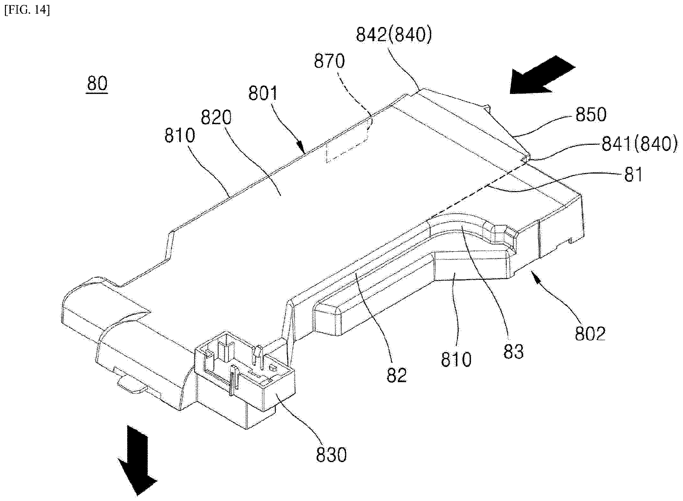

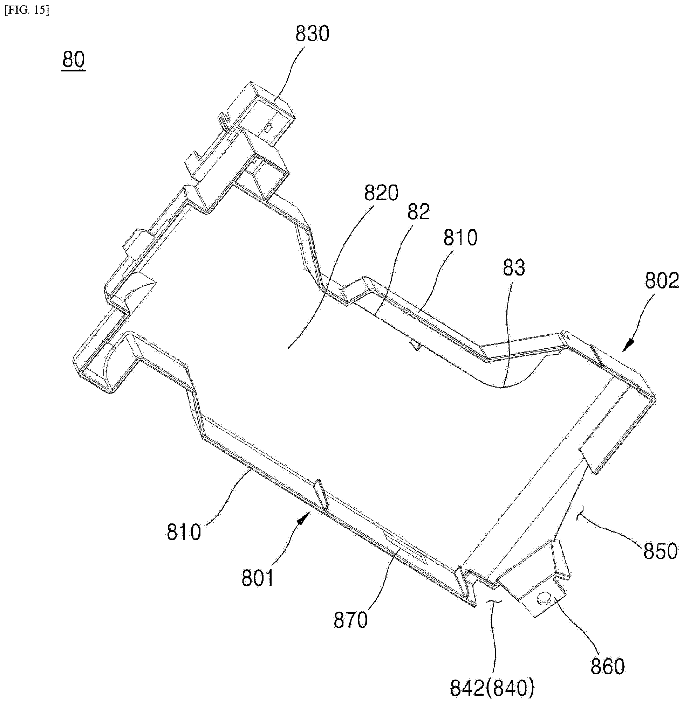

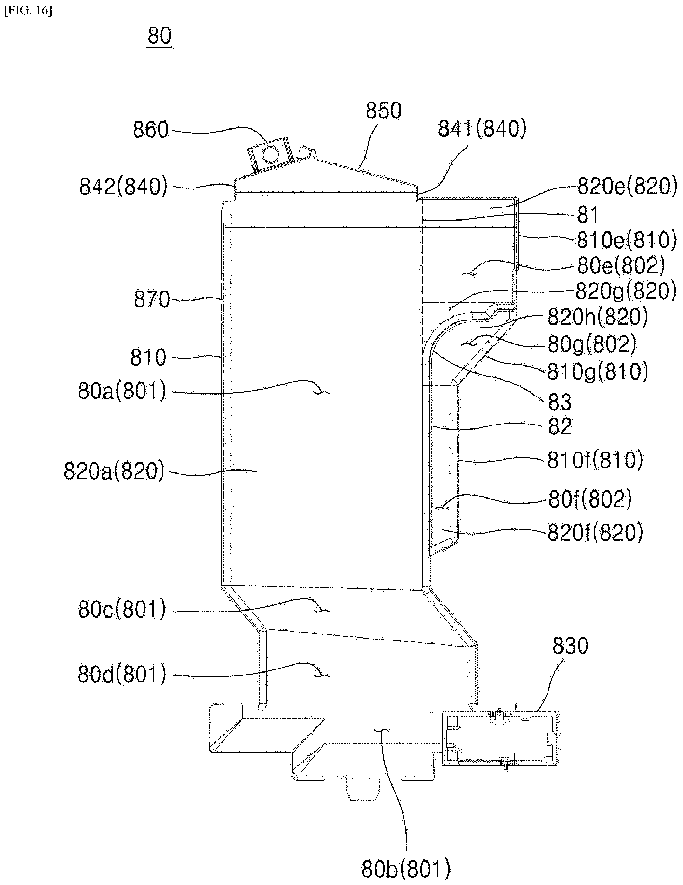

FIG. 14 is a perspective view of the air guide 80 according to a first embodiment. FIG. 15 is a perspective view of FIG. 14 viewed from a different direction. FIG. 16 is a plan view of FIG. 14.

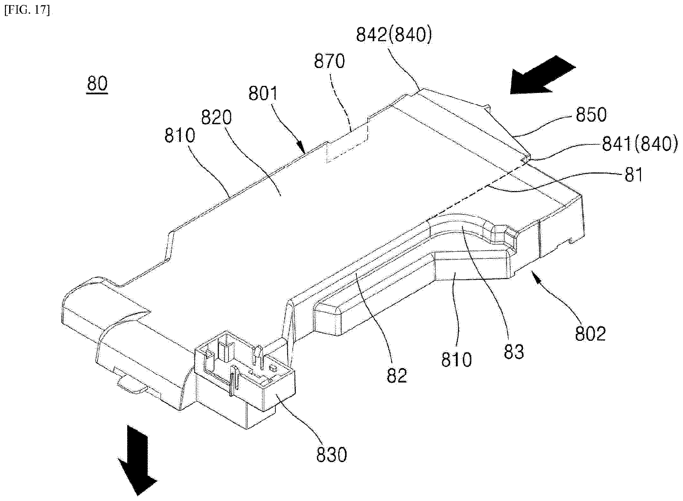

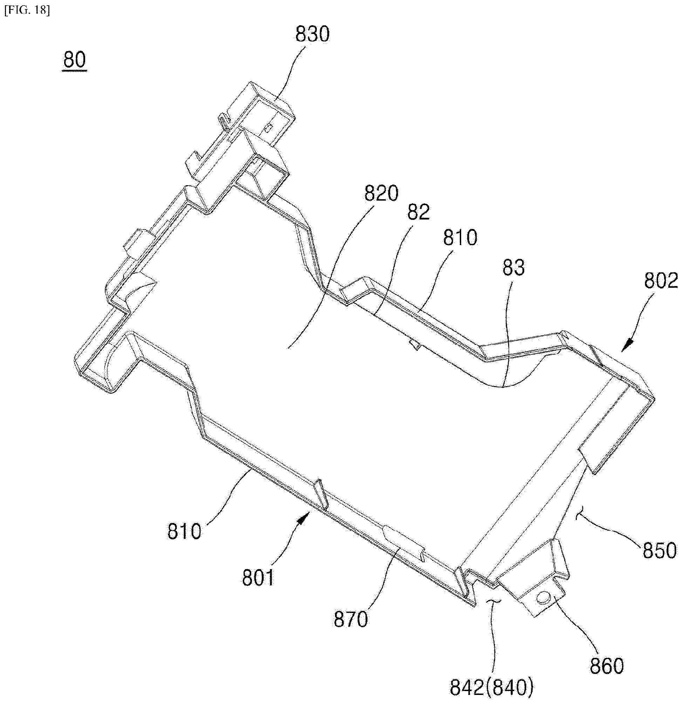

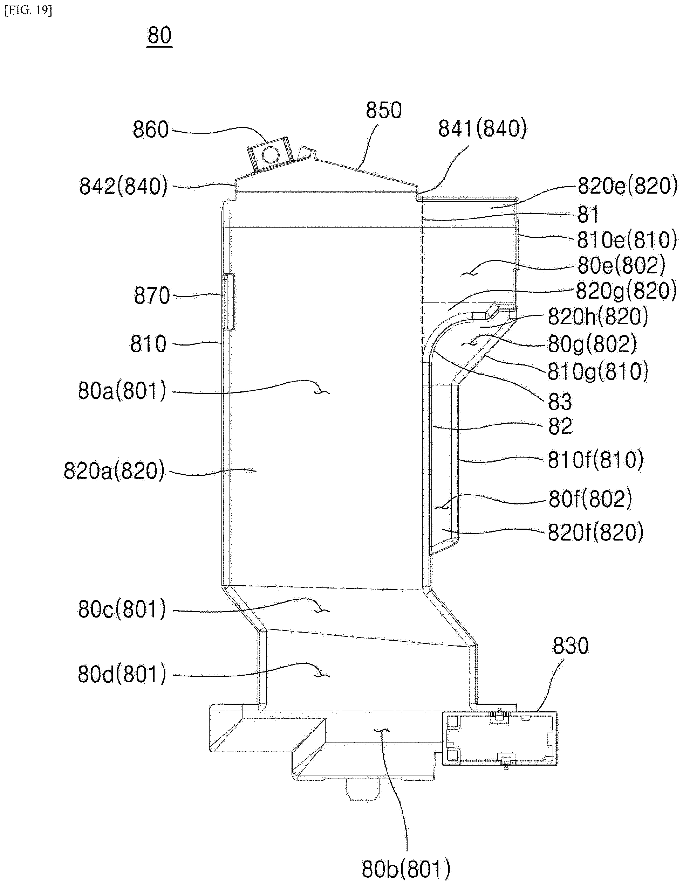

FIG. 17 is a perspective view of the air guide 80 according to a second embodiment. FIG. 18 is a perspective view of FIG. 17 viewed from a different direction. FIG. 19 is a plan view of FIG. 17.

Meanwhile, except for the shape of an air discharge hole 870, the air guide 80 according to a first embodiment of the present disclosure and the air guide 80 according to a second embodiment of the present disclosure have the same shape.

Referring to FIGS. 14 to 20, the air guide 80 may be provided to communicate with the air blower fan 70.

The air guide 80 may be provided to surround the heat sink 60 and the first group of electronic components 54, 55. A flow path of air that cools the heat sink 60 and the first electronic component 54, 55 may be formed inside the air guide 80.

The air guide 80 may be made of plastics that ensures easy of injection molding and electrical insulation, but the material is not limited thereto.

The arrows illustrated in FIGS. 14 and 17 may indicate the direction of air flow outside the air guide 80. Referring to FIGS. 14 and 17, the air guide 80 may change the direction of air flow.

The entrance of the air guide 80 may communicate with the air blower fan 70. The air flowing into the entrance of the air guide 80 may flow toward the exit of the air guide 80. The air may flow in the upward-downward direction of the electric range at the exit of the air guide 80.

With this structure, the air discharged from the air blower fan 70 may flow in the frontward-rearward direction of the electric range at the entrance of the air guide 80, and be discharged in a downward direction of the electric range at the exit of the air guide 80.

Meanwhile, based on the entrance of the air guide 80, the front and rear sides of the air guide 80 may be defined. That is, the front side of the air guide 80 is close to the entrance of the air guide 80, and the rear side of the air guide 80 is close to the exit of the air guide 80.

The air guide 80 may be detachably coupled to the base bracket 50. For example, the entrance of the air guide 80 into which the air discharged from the air blower fan 70 flows may be coupled to the base bracket 50 by a coupling tool, such as a screw bolt. Additionally, the exit of the air guide 80, through which air is discharged, may be shape-fitted to the base bracket 50.

The air guide 80 may include a pair of side wall 810 and an upper wall 820. A flow space in which air flows by the pair of side walls 810 and the upper wall 820 may be formed in the air guide 80. That is, the flow space of the air guide 80 may be defined by the pair of side walls 810 and the upper wall 820.

The side walls 810 may be disposed on the left and right sides of the heat sink 60, respectively. The upper wall 820 may be coupled to the upper end of the pair of side walls 810 and may be provided to cover the heat sink 60 and the first group of electronic components 54, and may be bent at the entrance and exit of the air guide 80.

The heat sink 60 and the first group of electronic components 54, 55 are disposed in the flow space of the air guide 80 and may be cooled by air flowing in the flow space.

The air guide 80 may be provided with a communication board installation portion 830. The communication board installation portion 830 may be disposed in a portion that protrudes from an end portion of the upper bracket 40 laterally, in a state in which the air guide 80 is mounted onto the electric range.

A wireless communication circuit board mounted onto the communication board installation portion 830 may be disposed not to vertically overlap the upper bracket 40 made of metal. Accordingly, the wireless communication circuit board may smoothly communicate with an external device, without being interfered with by jamming of the upper bracket 40 made of metal.

Referring to FIGS. 14, 16, 17 and 18, the air guide 80 may be distinguished by a first part 801 and a second part 802. The first part 801 and second part 802 of the air guide 80 may be distinguished by a first virtual plane 81. The first part 801 and second part 802 of the air guide 80 may be spaces into which the flow space of air, formed in the air guide 80, may be divided. Accordingly, the first part 801 and second part 802 of the air guide 80 may be in communication with each other.

The first part 801 of the air guide 80 may be a main part of the air guide 80. The first part of the air guide 80 may communicate with the air blower fan 70. The air blower fan 70 may discharge air toward the rear side (i.e., first side) of the heat sink 60. A first internal flow path among internal flow paths of air may be formed in the first part 801 of the air guide 80.

The second part 802 of the air guide 80 may be a sub part of the air guide 80. The second part 802 of the air guide 80 may be formed to protrude from the right side of the first part 801 of the air guide 80. A second internal flow path among the internal flow paths of air may be formed in the second part 802 of the air guide 80.

Meanwhile, based on the vane portion 53 and the inclined surface 63 on the right side of the heat sink 60, the internal flow path of air may be divided into the first internal flow path and the second internal flow path. Also, considering the location and shape of the vane portion 53, the amount of air flowing into the first internal flow path may be greater than the amount of air flowing into the second internal flow path.

A communication portion 850 and a guide coupling portion 860 may be formed in the first part 801 of the air guide 80.

The communication portion 850 may communicate with the exit of the air blower fan 70. The air forced to flow by the air blower fan 70 may flow into the inside the air guide 80 through the exit of the air blower fan 70 and the communication portion 850 and flow through the internal flow path.

The guide coupling portion 860 may protrude from the entrance of the air guide 80, and may couple the entrance of the air guide 80 to the base bracket 50. The guide coupling portion 860 may be mounted on the base bracket 50 using a coupling mechanism such as a screw bolt.

Referring to FIGS. 14 to 20, the first part 801 of the air guide 80 may further include a front air discharge port 840. The front air discharge port 840 may discharge some of the air supplied to the entrance of the air guide 80 to the outside of the air guide 80.

The front air discharge port 840 may include a front right air discharge port 841 formed on the right side of the communication portion 850, and a first air discharge port 842 formed on the left side of the communication portion 850.

The front right air discharge port 841 may be disposed at a location connected to the communication portion 850. A portion of the first air discharge port 842 may be formed to be surrounded by the guide coupling portion 860. The first air discharge port 841 and the second air discharge port 842 may be formed so that the flow directions of air are opposite to each other, and may be formed in locations that are approximately symmetrical with respect to the guide coupling portion 860. The front and right air discharge port 841 may discharge air to the left side of the air guide 80. The first air discharge port 842 may discharge air to the right side of the air guide 80.

The first-2 group of electronic components 54 among the first group of electronic components 54, 55 may be disposed in the second part 802 of the air guide 80. A second internal flow path may be formed in the second part 802 of the air guide 80. The air flowing through the second internal flow path may cool the first-2 group of electronic components 54.

Referring to FIGS. 16 and 19, the first part 801 of the air guide 80 may include a first area 80a, a second area 80b, a third area 80c, and a fourth area 80d. The second part 802 of the air guide 80 may include a fifth area 80e, a sixth area 80f, and a seventh area 80g. The fifth to seventh areas 80e, 80f, 80g may be formed adjacent to the communication portion 850 and protrude from the right side of the first part 801 of the air guide 80. The first to seventh areas 80a, 80b, 80c, 80d, 80e, 80f, 80g may be spaces into which the flow space of air, formed in the air guide 80, may be divided.

The first internal flow path among the internal flow paths of the air guide 80 may be formed in the first to fourth areas 80a, 80b, 80c, 80d, and the second internal flow path among the internal flow paths of the air guide 80 may be formed in the fifth to seventh areas 80e, 80f, 80g.

The front air discharge port 840, the communication portion 850, the guide coupling portion 860, and an air discharge hole 870 may be formed in the first area 80a. Additionally, the heat sink 60 may be disposed in the first area 80a.

The air flowing into the entrance of the air guide 80 passes through the first area 80a of the air guide 80 and flows through the heat sink 60, thereby cooling the heat sink 60 and the first-1 group of electronic devices.

The second area 80b may be bent in the upward-downward direction of the base bracket 50 and guide air to be discharged to the outside. The second area 80b is formed to face in downward direction of the electric range, so that the flow direction of air flowing into the air guide 80 can be changed. That is, the upper wall 820 defining the second area 80b may be bent downward, and the air discharged from the second area 80b may be directed to the lower portion of the case 10.

Due to the above-described structure, as illustrated by the arrows in FIGS. 14 and 17, the air discharged from the air blower fan 70 may flow into the air guide 80 in the frontward-rearward direction of the electric range, and exit the air guide 80 in the downward direction of the electric range.

The third area 80c and the fourth area 80d may be provided between the first area 80a and the second area 80b.

The third area 80c may extend from the first area 80a, and change a flow direction of air having passed through the first area 80a. The side wall 810 defining the third area 80c may be bent from the end portion of the first area 80a to have a slant. With this structure, air may flow at a slant in the frontward-rearward direction of the air guide 80, in the third area 80c. In addition, when the air guide 80 is mounted onto the base bracket 50, in the portion overlapping with the air guide 80 in the upward-downward direction, interference between the electronic device mounted on the printed circuit board 51 and the side wall 810 can be avoided.

The fourth area 80d may extend from the third area 80c, communicate with the second area 80b, and change a flow direction of air having passed through the third area 80c. The side wall 810 defining the fourth area 80d may be bent from an end portion of the third area 80c to have a slant. With this structure, in the fourth area 80d, the air flow direction of the air guide 80 may be restored to the frontward-rearward direction of the air guide 80.

The air having passed through the fourth area 80d may be discharged from the lower portion of the electric range through the second area 80b. Referring to FIGS. 16 and 19 , the air having flown to the exit of the fourth area 80d in the air guide 80 in the frontward-rearward direction of the electric range changes its flow direction in the second area 80b, and flows to the lower portion of the electric range through the exit of the second area 80b and is discharged from the air guide 80.

The fifth area 80e may be formed adjacent to the air blower fan 70 on the right side of the first area 80a. The side wall 810e of the fifth area 80e may be formed parallel to the side wall 810 defining the first area 80a. The upper wall 820e of the fifth area 80e may be formed at the same height as the upper wall 820a of the first area 80a. The upper wall 820e of the fifth area 80e may be bent at the rear side of the fifth area 80e. The DC link capacitor 54a may be disposed in the fifth area 80e.

The sixth area 80f may be formed on the right side of the first area 80a and forward of the fifth area 80e. The side wall 810f of the sixth area 80f may be formed parallel to the side wall 810 defining the first area 80a, but may be formed to be inclined at the front side of the sixth area 80f. The snubber capacitor 54b may be disposed in the sixth area 80f.

Referring to FIGS. 14 to 19, the sixth area 80f may be formed to be stepped from the first area 80a. That is, the upper wall 820a defining the first area 80a and the upper wall 820f defining the sixth area 80f may be connected by a first upper wall connecting portion 82. The upper wall 820f defining the sixth area 80f may have a height lower than that of the upper wall 820a defining the first area 80a. Due to this structure, when the air guide 80 is mounted on the base bracket 50, the device connected to the printed circuit board 51 may be prevented from interfering with the upper wall 820f defining the sixth area 80f.

The side wall 810f of the sixth area 80f may be bent to be inclined at an end portion of the sixth area 80f and connected to the side wall 810 defining the first area 80a.

The seventh area 80g may be formed on the right side of the first area 80a. The seventh area 80g may connect the fifth area 80e and the sixth area 80f. The shunt resistor 54c may be disposed in the seventh area 80g.

Referring to FIGS. 14 to 19, the upper walls 820g, 820h of the seventh area 80g may include the upper wall 820g with a first height and the upper wall 820h with a second height. The upper wall 820g with the first height in the seventh area 80g and the upper wall 820h with the second height in the seventh area 80g may be connected by a second upper wall connecting portion 83.

The upper wall 820g with the first height in the seventh area 80g may have the same height as the upper wall 820a in the first area 80a and the upper wall 820f in the sixth area 80f. The upper wall 820h with the second height in the seventh area 80g may have the same height as the upper wall 820f in the sixth area 80f.

The second upper wall connecting portion 83 may have an inclined shape with respect to the side wall 810 defining the first area 80a. In particular, the second upper wall connecting portion 83 may be inclined in a curved shape. Through this, the generation of interference between the air guide 80 and the wire connected to the first terminal 57 can be avoided.

The side wall 810e of the fifth area 80e and the side wall 810f of the sixth area 80f may be connected through the side wall 810g of the seventh area 80g. In this case, the side wall 810g of the seventh area 80g may be formed to be inclined with respect to the side wall 810 defining the first area 80a.

Meanwhile, the air discharge hole 870 may be an air discharge port different from the front air discharge port 840. The air discharge hole 870 may be formed in the first part 801. The air discharge hole 870 may be formed in the first part 801 further away from the air blower fan 70 (i.e., the entrance of the air guide 80) than the front air discharge port 840. The air discharge hole 870 may discharge some of the air flowing in the first internal flow path of the air guide 80 to the outside of the air guide 80.

Specifically, the air discharge hole 870 may be formed on the left outer wall of the air guide 80. The air discharge hole 870 may provide air to the second group of electronic devices 56 mounted on the printed circuit board 51 from the left exterior of the air guide 80.

Referring to FIGS. 14 to 16, the air discharge hole 870 may be formed only on the left side wall 810 of the pair of side walls 810.

Alternatively, referring to FIGS. 17 to 20, the air discharge hole 870 may be formed across the left side wall 810 of the pair of side walls 810 and the upper wall 820 connected to the left side wall 810. Since the air discharge hole 870 is formed across the left side wall 810 and the upper wall 820, the air discharge hole 870 can be perforated more easily when manufacturing the air guide 80. Meanwhile, a portion of the air discharge hole 870 formed in the upper wall 820 may be smaller in size than the other portion of the air discharge hole 870 formed in the left side wall 810.

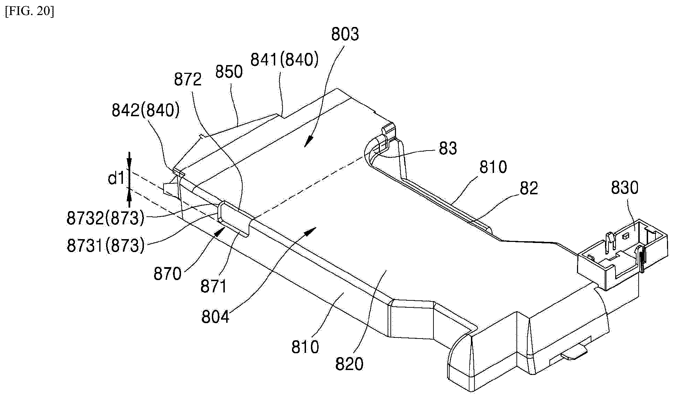

For convenience of description below, with further reference to FIGS. 20 to 22 based on a second embodiment in which the air discharge hole 870 is formed across the left side wall 810 and the upper wall 820, the formation location of the air discharge hole 870 and the air flow path will be described in detail.

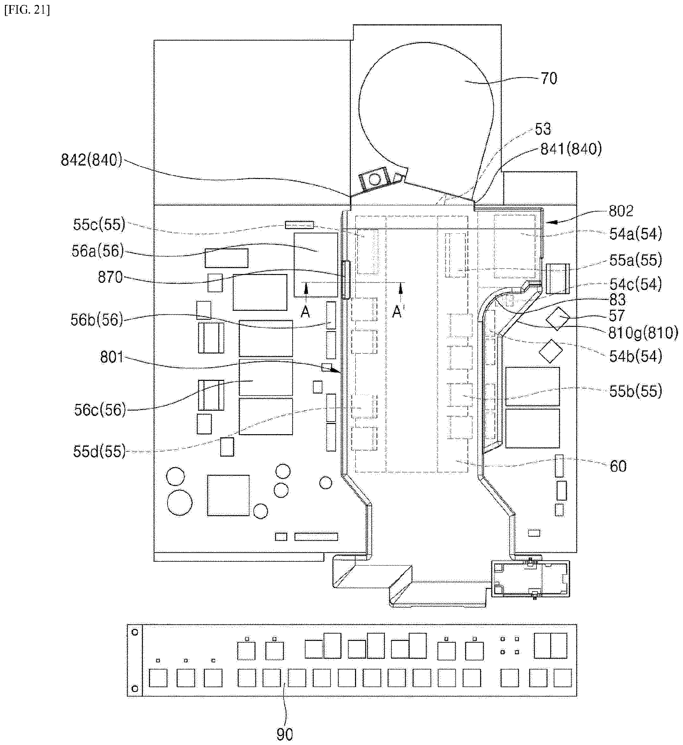

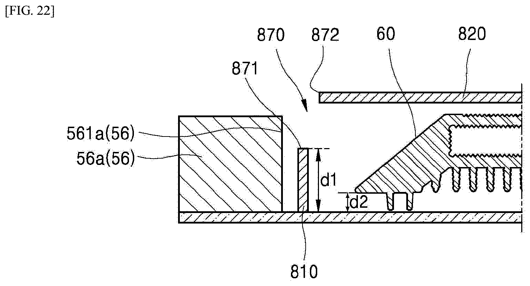

FIG. 20 is a perspective view of FIG. 17 viewed from another direction. FIG. 21 is a plan view explaining the installation structure of the air guide according to the second embodiment. FIG. 22 is a cross-sectional view taken along line A-A' illustrated in FIG. 21.

Referring to FIGS. 17 to 22, the first area 80a included in the first part 801 of the air guide 80 may define the entrance of the air guide 80 where the communication portion 850 is formed. The heat sink 60 may be disposed in the first area 80a. On the right side of the first area 80a, the fifth to seventh areas 80e, 80f, 80g constituting the second part 801 of the air guide 80 may be formed.

A plurality of left electronic components 55c, 55d may be disposed on the left side of the heat sink 60, that is, between the left inclined surface 630 of the heat sink 60 and the left side wall 810 of the first area 80a. A plurality of right electronic components 55a, 55b may be disposed on the right side of the heat sink 60, that is, between the right inclined surface 630 of the heat sink 60 and the right side wall 810 of the second portion 802. The plurality of left electronic devices 55c, 55d and the plurality of right electronic devices 55a, 55b may be attached to the inclined surface 630 of the heat sink 60. Meanwhile, the plurality of left electronic devices 55c, 55d and the plurality of right electronic devices 55a, 55b may be arranged to be spaced apart from the inclined surface 630 of the heat sink 60 by a predetermined distance.

The plurality of left electronic devices 55c, 55d and the plurality of right electronic devices 55a, 55b may be sequentially arranged along the first internal flow path of air. That is, the rectifying devices 55a, 55c may be placed closer to the communication portion 850, and the plurality of inverter switching devices 55b, 55d may be placed further away from the communication portion 850 than the rectifying device 55a, 55c.

The air discharge hole 870 formed in the first area 80a may have an overall rectangular shape. The air discharge hole 870 may include a lower end 871, an upper end 872, and a pair of side ends 873.

The lower end 871 of the air discharge hole 870 may be located on the left side wall 810 of the air guide 80. Here, the lower end 871 of the air discharge hole 870 may be located to be spaced apart from the printed circuit board 51 by a preset distance d1. That is, the lower end 871 of the air discharge hole 870 may not contact the printed circuit board 51.

The upper end 872 of the air discharge hole 870 may be located on the upper wall 820 of the air guide 80. The pair of side ends 873 of the air discharge hole 870 may connect the upper end 872 of the air discharge hole 870 and the lower end 871 of the air discharge hole 870. The side end 873 of the air discharge hole 870 may include a straight first side end 8731 located on the left side wall 810 of the air guide 80 and a curved second side end 8732 located on the upper wall 820 of the air guide 80.

In the above structure, the air discharge hole 870 may be formed across the left side wall 810 and upper wall 820 of the first area 80a. In addition, the air discharge hole 870 may be formed at a first point of the first area 80a, which corresponds to an area between the rectifying device 55c and the plurality of inverter switching devices 55d.

Specifically, the air discharge hole 870 may be formed in front of the plurality of inverter switching devices 55d. That is, the air discharge hole 870 may be disposed closer to the air blower fan 70 (i.e., the entrance of the air guide 80) than the plurality of inverter switching devices 55d. In other words, the air discharge hole 870 may be disposed closer to the air blower fan 70 than the inverter switching device 55d that is disposed first among the plurality of inverter switching devices 55d. Accordingly, the air discharge hole 870 may be formed so as not to overlap the plurality of inverter switching devices 55d. In addition, the air discharge hole 870 may be formed to overlap the rectifying device 55c. However, the present disclosure is not limited to this, and the air discharge hole 870 may be formed so as not to overlap the rectifying device 55c.

Meanwhile, with particular reference to FIG. 20, the air guide 80 may also be divided into a third part 803 and a fourth part 804. The third and fourth parts 803, 804 of the air guide 80 may be separated by a second virtual plane 85. The third and fourth parts 803, 804 of the air guide 80 may be spaces into which the flow space of air, formed in the air guide 80, may be divided. Therefore, the third and fourth parts 803, 804 of the air guide 80 may be in communication with each other, and the air inside the air guide 80 may flow into the third part 803 and then may flow into the fourth part 804. The third part 803 may be referred to as part A, and the fourth part 804 may be referred to as part B. The second virtual plane 85 may correspond to a boundary between the third part 803 and the fourth part 804.

The third part 803 may be a part located close to the communication portion 850. The third part 803 may include a portion of the previously mentioned first area 80a and the fifth area 80e.

The fourth part 804 may be farther from the communication portion 850 than the third part 803. The fourth part 804 may be a part excluding the third part 803. In particular, the area adjacent to the third part 803 of the fourth part 804 may include the remaining portion of the first area 80a and the seventh area 80f.

In the above structure, the air discharge hole 870 may be formed in the third part 803 at the boundary between the third part 803 and the fourth part 804. For example, the rear side end 873 of the air discharge hole 870 may contact the boundary between the third part 803 and the fourth part 804.

Meanwhile, with particular reference to FIGS. 21 and 22, the second group of electronic devices 56 disposed on the left side of the air guide 80 may include the DC link capacitor 56a, the snubber capacitor 56b, and the SMPS 56c. In this case, the DC link capacitor 56a, which is a first outer electronic device among the second group of electronic devices 56, may be disposed adjacent to the air discharge hole 870.

Here, the height of the DC link capacitor 56a may be greater than the height d1 of the lower end 871 of the air discharge hole 870. That is, the height of the second side 561a of the DC link capacitor 56a adjacent to the air discharge hole 870 may be greater than the height d1 of the lower end 871 of the air discharge hole 870.

In addition, the heat sink 60 may have an overall trapezoidal shape. In this case, it may be greater than the height d2 of the bottom of the inclined surface 630 of the heat sink 60.

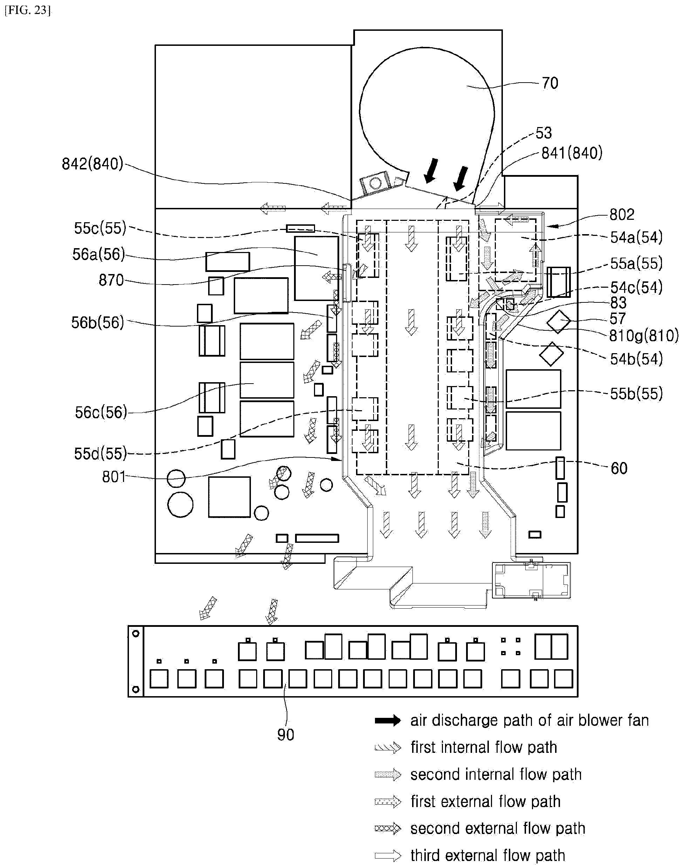

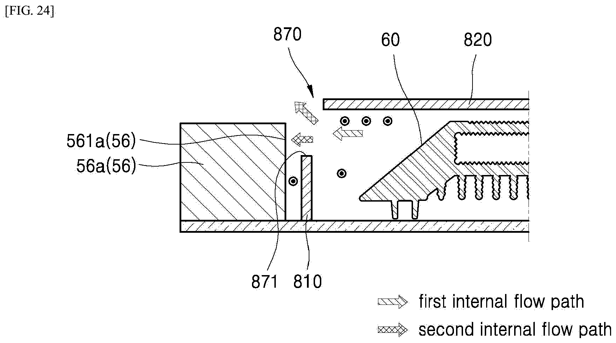

Hereinafter, with reference to FIGS. 23 and 24, the flow of air discharged from the air blower fan 70 will be summarized.

FIG. 23 is a plan view illustrating the flow path of air inside and outside the air guide according to an embodiment of the present disclosure. FIG. 24 is a cross-sectional view taken along line A-A' illustrated in FIG. 23.

Referring to FIGS. 23 and 24, the air blower fan 70 may be introduced into the air guide 80 through the communication portion 850. Most of the air flowing into the communication portion 850 may flow into the internal air flow path formed inside the air guide 80.

Due to the inclined shape of the vane portion 53 and heat sink 60, the internal flow path of air can be divided into the first internal flow path and the second internal flow path. Here, the first internal flow path may be formed in the first part 801 of the air guide 80, and the second internal flow path may be formed in the second part 802 of the air guide 80.

The air flowing through the first internal flow path may flow along the flow path 620, inclined portion 630, and flat portion 640 of the heat sink 60. Accordingly, the air flowing through the first internal flow path can cool the heat sink 60 and the first-1 group of electronic devices 55.

The air flowing through the second internal flow path may collide with the first-2 group of electronic devices 54. Accordingly, the air flowing through the second internal flow path can cool the first-1 group of electronic devices 55.

Specifically, some of the air flowing into the second internal flow path may collide with the side wall 810g of the inclined seventh area 80g and diverge in both directions. Some of the branched air may flow into the first internal flow path and the second internal flow path, and another portion of the branched air may flow into the fifth area 80e. That is, another portion of the branched air may flow in the reverse direction of the second internal flow path.

The air flowing in the reverse direction may flow to at least one of the left, upper, and rear sides of the DC link capacitor 54a. That is, air may flow throughout the fifth area 80e due to another portion of the branched air. Accordingly, the cooling efficiency of the DC link capacitor 54a can be increased.

In addition, some of the air flowing into the second internal flow path may collide with the inclined second upper wall connecting portion 83 and diverge in both directions. Some of the branched air may flow into the first internal flow path, and another portion of the branched air may flow into the fifth area 80e. That is, another portion of the branched air may flow in the reverse direction of the second internal flow path.

The air flowing in the reverse direction may flow to the left, upper, and rear sides of the DC link capacitor 54a. In particular, due to the curved second upper wall connecting portion 83, air turbulence may occur around the second upper wall connecting portion 83. Accordingly, the cooling efficiency of the DC link capacitor 54a can be further increased by the air turbulence.

In addition, the end portion of the side wall 810g of the sixth area 80f is formed to be inclined, so that air flowing into the second internal flow path can flow naturally and cooling efficiency can be increased.

The air flowing into the second internal flow path may join at the end portion of the first area 80a and flow into the first internal flow path. Accordingly, high-temperature air that has cooled the heat sink 60, some electronic devices 54, and other electronic devices 55 may be discharged through the exit of the air guide 80.

Meanwhile, some of the air flowing into the communication portion 850 may be discharged to the outside of the air guide 80 through the front air discharge port 840 and flow into the external flow path. That is, the air discharged from the air blower fan 70 may be discharged to the outside of the left side of the air guide 80 through the first air discharge port 842 and flow into the first external flow path, and the air may be discharged to the outside of the right side of the air guide 80 through the first air discharge port 842 and flow into the third external flow path. The air flowing in the first external flow path may be provided to the second group of electronic devices 56, and the air flowing in the third external flow path may be provided to the electronic devices disposed outside the right side of the air guide 80.

Meanwhile, an additional external air flow path, that is, a second external flow path, may be formed based on the air discharge hole 870 formed in the air guide 80.

Specifically, the air flowing to the left side of the heat sink 60 (hereinafter referred to as "left flowing air") among the air flowing in the first internal flow path may cool the plurality of left electronic devices 55c, 55d disposed on the left side of the heat sink 60. In addition, the air discharge hole 870 may discharge some air of the left flowing air to the outside of the air guide 80. The air discharged through the air discharge hole 870 can cool the second group of electronic devices 56.

That is, based on the air that is discharged from the front and right air discharge port 842 (i.e., first air discharge port) located close to the air blower fan 70 and flows into the first external flow path, and the air that is discharged to the air discharge hole 870 (i.e., second air discharge port) located far from the air blower fan 70 and flows into the second external flow path, the second group of electronic devices 56 can be cooled. Accordingly, the flow rate of air provided to the second group of electronic devices 56 can be increased, and the cooling efficiency of the second group of electronic devices can be increased.

In addition, some air of the left flowing air that has cooled the rectifying device 55c may be discharged through the air discharge hole 870, and the remaining air may flow in the direction of the plurality of inverter switching devices 55d.

Meanwhile, the plurality of inverter switching devices 55d generate a large amount of heat. If the plurality of inverter switching devices 55d is located closer to the air blower fan 70 than the air discharge hole 870, the air that has cooled the plurality of inverter switching devices 55d is heated, and the heated air may be discharged through the air discharge hole 870. In this case, the cooling efficiency of the second group of electronic devices 56 is reduced.

In order to solve the above problem, the air discharge hole 870 may be located closer to the air blower fan 70 than the plurality of inverter switching devices 55d. Accordingly, relatively cool air can be provided to the second group of electronic devices 56, and the cooling efficiency of the second group of electronic devices 56 can be increased.

In particular, the air discharge hole 870 may also be formed in the upper wall 820 of the air guide 80. Accordingly, the left flowing air can be further discharged through a portion of the air discharge hole 870 formed in the upper wall 820, and the air can flow to a more distant area. Ultimately, the cooling efficiency of the second group of electronic devices 56 can be further increased.

In addition, the air guide 80 may be divided into the third part 803 and the fourth part 804 by the second virtual plane 85. In this case, the area of the fourth part 804 adjacent to the third part 803 may have an overall trapezoidal shape. That is, the area of the third part 803 may be larger than the area of the fourth part 804.

If the air discharge hole 870 is formed in the fourth part 804, the flow rate in the fourth part 804 may decrease due to the air discharged through the air discharge hole 870. If the flow rate in the fourth part 804 decreases, the cooling efficiency of the first group of electronic devices 54, 55 disposed in the fourth part 804 may decrease.

To solve the above problem, the air discharge hole 870 may be formed in the third part 803 at the boundary between the third part 803 and the fourth part 804. In this case, the air discharge hole 870 may be formed to contact the boundary between the third part 803 and the fourth part 804. Therefore, it is possible to minimize the decrease in cooling efficiency of the first group of electronic devices 54, 55 disposed in the fourth part 804. As a result, the first group of electronic devices and the second group of electronic devices 54, 55, 56 can all be cooled effectively.

In addition, with particular reference to FIG. 24 , the lower end 871 of the air discharge hole 870 may be located to be spaced apart from the printed circuit board 51 by a preset distance d1. Further, the height d1 of the lower end 871 of the air discharge hole 870 may be greater than the height of the lower surface of the trapezoidal heat sink 60 disposed inside the air guide 80, that is, the height d2 of the bottom of the inclined surface 630 of the heat sink 60.

Due to this structure, a distance between the side wall 810 of the air guide 80 and the upper side of the inclined surface 630 of the heat sink 60 may be greater than a distance between the side wall 810 of the air guide 80 and the lower side of the inclined surface 630 of the heat sink 60, and the flow rate of air flowing toward the side wall 810 of the air guide 80 and the upper side of the inclined surface 630 of the heat sink 60 may be greater than the flow rate of air flowing toward the side wall 810 of the air guide 80 and the lower side of the inclined surface 630 of the heat sink 60. In this case, the air discharge hole 870 may be formed on the upper side of the side wall 810 of the air guide 80. Accordingly, a greater flow rate of air can be discharged through the air discharge hole 870, so that the cooling efficiency of the second group of electronic devices 56 can be further increased.

In addition, the air discharge hole 870 may be formed in the air guide 80 while being adjacent to the DC link capacitor 56a among the second group of electronic devices 56. In this case, the height of the second side 561a of the DC link capacitor 56a may be greater than the height d1 of the lower end 871 of the air discharge hole 870. Therefore, the air discharged from the air discharge hole 870 may collide with the second side 561a of the DC link capacitor 56a and may flow into the area of the printed circuit board 51 where the second group of electronic devices 56 is disposed.

In particular, the control board 90 is provided adjacent to the exit of the air guide 80, and the air discharged from the air discharge hole 870 may collide with the second side 561a of the DC link capacitor 56a and may flow further in the direction in which the control board 90 is disposed. Accordingly, the control board 90 can also be cooled, and damage to the control board 90 can be prevented.

The present disclosure has been described with reference to the embodiments illustrated in the drawings. However, the disclosure is not limited to the embodiments and the drawings set forth herein. Further, various modifications may be made by one having ordinary skill in the art within the scope of the technical spirit of the disclosure. Further, though not explicitly described during description of the embodiments of the disclosure, effects and predictable effects according to the configuration of the disclosure should be included in the scope of the disclosure.

## Claims

1. An electric range, comprising:
a base bracket on which a printed circuit board equipped with a plurality of electronic devices is installed;
an air blower fan which is installed on the base bracket and discharges air; and
an air guide which surrounds some of the plurality of electronic devices, communicates with the air blower fan, and forms a flow path of the air discharged from the air blower fan,
wherein the air guide includes an air discharge hole which provides a portion of flowing air to an electronic device disposed outside the air guide.

2. The electric range of claim 1, further comprising a heat sink which is installed on the printed circuit board,
wherein among a first group of electronic device of the plurality of electronic devices, a plurality of first side electronic devices is disposed between a first side of the heat sink and a first side of the air guide,
the air flowing to the first side of the heat sink cools the plurality of first side electronic devices.

3. The electric range of claim 2, wherein the air guide is formed so that an air flow direction and the air discharge hole are formed to be opposite to each other, and the air guide includes a first air discharge port formed closer to the air blower fan than the air discharge hole.

4. The electric range of claim 2, where the plurality of first side electronic devices include at least one first inner electronic device and at least one second inner electronic device arranged sequentially along a direction of a flow path of the air,
the air discharge hole is formed at a first point of the air guide corresponding to an area between the at least one first inner electronic device and the at least one second inner electronic device.

5. The electric range of claim 4, wherein the air discharge hole is formed not to overlap the at least one second inner electronic device.

6. The electric range of claim 4, wherein the air discharge hole is formed in a first area of the air guide so as not to overlap with the second inner electronic device disposed first among the at least one second inner electronic device.

7. The electric range of claim 4, wherein the air discharge hole is formed to overlap the at least one first inner electronic device.

8. The electric range of claim 4, wherein the at least one first inner electronic device corresponds to a rectifying device for driving a heater.

9. The electric range of claim 4, wherein the at least one second inner electronic device corresponds to an inverter switching device for driving a heater.

10. The electric range of claim 2, wherein the air blower fan communicates with an entrance of the air guide,
the plurality of first side electronic devices include at least one first inner electronic device and at least one second inner electronic device which are sequentially disposed with respect to the entrance of the air guide,
the air discharge hole is disposed closer to the air blower fan than the at least one second internal electronic device.

11. The electric range of claim 1, wherein a communication portion communicating with the air blower fan is formed at an entrance of the air guide,
an area of part A of the air guide adjacent to the communicating portion is larger than an area of part B of the air guide which is further away from the communication portion than the part A,
the air discharge hole is formed in part A at a boundary between the part A and the part B.

12. The electric range of claim 1, further comprising an upper bracket which is disposed on an upper portion of the base bracket,
wherein the air guide includes a pair of side walls and an upper wall coupled to an upper end of the pair of side walls,
the air discharge hole is formed on a first side of the air guide among the pair of side walls of the air guide.

13. The electric range of claim 12, wherein the air discharge hole is formed across the first side of the air guide and the upper wall of the air guide.

14. The electric range of claim 12, wherein a lower end of the air discharge hole is formed to be spaced apart from the printed circuit board by a preset distance.

15. The electric range of claim 1, wherein a second group of electronic devices of the plurality of electronic device groups is disposed on an outside of a first side of the air guide,
the air discharge hole is disposed on an outer wall of the first side of the air guide to discharge a portion of the air to the outside of the first side of the air guide and provide the portion of the air to the second group of electronic devices.

16. The electric range of claim 15, wherein the second group of electronic devices includes a first outer electronic device disposed adjacent to the air discharge hole,
a height of the first outer electronic device is higher than a height of a lower end of the air discharge hole.

17. The electric range of claim 16, wherein the portion of the air collides with one surface of the first outer electronic device adjacent to the air discharge hole and then flows to an area of the printed circuit board on which the second group of electronic devices is disposed.

18. The electric range of claim 17, further comprising a control board which is disposed adjacent to an exit of the air guide,
the portion of the air further flows in a direction in which the control board is disposed after colliding with one surface of the first outer electronic device.

19. An electric range comprising:
a base bracket on which a printed circuit board equipped with a plurality of electronic devices including a first group of electronic devices and a second group of electronic devices is installed;
an air blower fan which is installed on the base bracket and discharges air; and
an air guide which surrounds the first group of electronic devices, communicates with the air blower fan, and forms an internal flow path of the air discharged from the air blower fan,
wherein the air guide includes a first air discharge port and second air discharge port which provide a portion of the air discharged from the air blower fan to the second group of electronic devices,
the first air discharge port is formed closer to the air blower fan than the second air discharge port,
the air discharged from the first air discharge port and the air discharged from the second air discharge port flow along different flow paths.

20. The electric range of claim 19, wherein the air blower fan communicates with an entrance of the air guide,
the first group of electronic devices includes a plurality of first side electronic devices,
the plurality of first side electronic devices include at least one first inner electronic device and at least one second inner electronic device which are sequentially disposed with respect to the entrance of the air guide,
the air discharge hole is disposed closer to the air blower fan than the at least one second internal electronic device.
